# DEMANDE DE BREVET EUROPEEN

(11) **EP 4 550 079 A1**
(43) Date de publication de la demande: **07.05.2025**
(21) Numéro de dépôt: 24209848.1
(22) Date de dépôt: 30.10.2024
(51) Int. Cl.: G05F 1/575

(54) **DISPOSITIF ELECTRONIQUE**

(30) Priorité: 03.11.2023 FR 2311974
(71) Demandeur: STMicroelectronics International N.V., 1228 Plan-les-Ouates, Geneva (CH)
(72) Inventeur: FORT, Jimmy, 13114 Puyloubier (FR)
(74) Mandataire: Cabinet Beaumont

(57) **Abrégé**

La présente description concerne un dispositif comprenant un régulateur de tension (18) comprenant :
des première (88) et deuxième (90) branches comprenant des premier (92, 106), deuxième (94, 108) et troisième (96, 110) transistors, les noeuds de commande des premiers transistors des première et deuxième branches étant reliés ensemble, le noeud de commande du troisième transistor de chaque première et deuxième branche étant relié au point milieu des premier et deuxième transistors de la même branche ;
un quatrième transistor (118) ; et
un cinquième transistor (120),
les noeuds de commande du quatrième transistor et du deuxième transistor de la première branche étant reliés ensemble à un noeud d'application d'une tension de consigne, les noeuds de commande du cinquième transistor et du deuxième transistor de la deuxième branche étant reliés ensemble à un noeud de sortie du régulateur.

## Description

### Domaine technique

La présente description concerne de façon générale les dispositifs électroniques et plus particulièrement les dispositifs électroniques comprenant des régulateurs de tension.

### Technique antérieure

Un régulateur de tension est un composant électronique configuré pour maintenir une tension sensiblement constante sur sa sortie. Les régulateurs de tension peuvent par exemple être des régulateurs linéaires, c'est-à-dire des régulateurs reposant sur un composant actif travaillant dans sa zone linéaire ou sur un composant passif, comme une diode Zener, travaillant dans sa zone inverse.

Un type de régulateurs linéaires correspond aux régulateurs dits à faible chute (LDO - Low Drop Out). Les régulateurs de ce type sont tels que la tension de sortie est très proche de la tension d'alimentation du régulateur.

### Résumé de l'invention

Un mode de réalisation prévoit un dispositif comprenant un régulateur de tension, le régulateur comprenant : des première et deuxième branches, chaque première et deuxième branche comprenant des premier, deuxième et troisième transistors reliés en série, dans cet ordre, entre un premier noeud d'application d'une tension d'alimentation et un deuxième noeud d'application d'une tension de référence, les noeuds de commande des premiers transistors des première et deuxième branches étant reliés ensemble, le noeud de commande du troisième transistor de chaque première et deuxième branche étant relié au point milieu des premier et deuxième transistors de la même branche ; un quatrième transistor relié entre le point milieu des deuxième et troisième transistors de la deuxième branche et un troisième noeud ; et un cinquième transistor relié entre le point milieu des deuxième et troisième transistors de la première branche et un quatrième noeud, les noeuds de commande du quatrième transistor et du deuxième transistor de la première branche étant reliés ensemble à un noeud d'application d'une tension de consigne, les noeuds de commande du cinquième transistor et du deuxième transistor de la deuxième branche étant reliés ensemble à un noeud de sortie du régulateur.

Selon un mode de réalisation, les premiers transistors des première et deuxième branches sont des transistors MOSFET à canal P, les deuxièmes et troisièmes transistors des première et deuxième branches sont des transistors MOSFET à canal N.

Selon un mode de réalisation, le régulateur comprend, reliés dans cet ordre en série entre les premier et deuxième noeuds, des sixième et septième transistors, une première résistance, et des huitième et neuvième transistors, le noeud de commande du sixième transistor étant relié au point milieu du septième transistor et de la résistance, le noeud de commande du sixième transistor étant en outre relié aux noeuds de commande des premiers transistors des première et deuxième branches, le noeud de commande du septième transistor étant relié au point milieu du transistor et de la résistance.

Selon un mode de réalisation, le régulateur comprend, reliés dans cet ordre en série entre les premier et deuxième noeuds, une source de courant, une deuxième résistance, et des dixième et onzième transistors, le noeud de commande du dixième transistor étant relié au point milieu de la deuxième résistance et de la source de courant et au noeud de commande du huitième transistor, le noeud de commande du onzième transistor étant relié au noeud de commande du neuvième transistor.

Selon un mode de réalisation, le régulateur comprend des douzième, treizième et quatorzième transistors reliés, dans cet ordre, en série entre les premier et deuxième noeuds, un noeud de commande du quatorzième transistor étant relié au noeud de commande du troisième transistor de la première branche, un noeud de commande du treizième transistor étant relié au noeud de commande du huitième transistor.

Selon un mode de réalisation, le régulateur comprend des quinzième, seizième et dix-septième transistors reliés, dans cet ordre, en série entre les premier et deuxième noeuds, un noeud de commande du dix-septième transistor étant relié au noeud de commande du troisième transistor de la deuxième branche, un noeud de commande du seizième transistor étant relié au noeud de commande du huitième transistor, un noeud de commande du quinzième transistor étant relié au noeud de commande du douzième transistor.

Selon un mode de réalisation, le régulateur comprend un dix-huitième transistor relié entre le premier noeud et le noeud de sortie du régulateur.

Selon un mode de réalisation, le régulateur comprend un dix-neuvième transistor, le dix-neuvième transistor étant relié en série entre les douzième et treizième transistors, un noeud de commande du dix-neuvième transistor étant relié au noeud de commande du septième transistor, un noeud de commande du douzième transistor étant relié au point milieu des dix-neuvième et treizième transistors.

Selon un mode de réalisation, le régulateur comprend un vingtième transistor, le vingtième transistor étant relié en série entre les quinzième et seizième transistors, un noeud de commande du vingtième transistor étant relié au noeud de commande du dix-neuvième transistor.

Selon un mode de réalisation, un noeud de commande du dix-huitième transistor est relié au point milieu des vingtième et seizième transistors.

Selon un mode de réalisation, un noeud de commande du treizième transistor est relié au point milieu des treizième et quatorzième transistors, un noeud de commande du dix-huitième transistor étant relié au point milieu des quinzième et seizième transistors.

Selon un mode de réalisation, le régulateur comprend un premier condensateur de Miller, le premier condensateur étant relié entre le noeud de sortie du régulateur et le point milieu des seizième et dix-septième transistors.

Selon un mode de réalisation, le régulateur comprend un deuxième condensateur de Miller, le deuxième condensateur étant relié entre le noeud de sortie du régulateur et le noeud de commande du troisième transistor de la première branche.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un exemple de dispositif électronique ;
la figure 2 représente un mode de réalisation d'un régulateur de tension ;
la figure 3 représente un autre mode de réalisation d'un régulateur de tension ;
la figure 4 représente un autre mode de réalisation d'un régulateur de tension ;
la figure 5 représente un autre mode de réalisation d'un régulateur de tension ;
la figure 6 représente une variante d'une partie du mode de réalisation de la figure 1 ;
la figure 7 représente un autre mode de réalisation d'un régulateur de tension.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

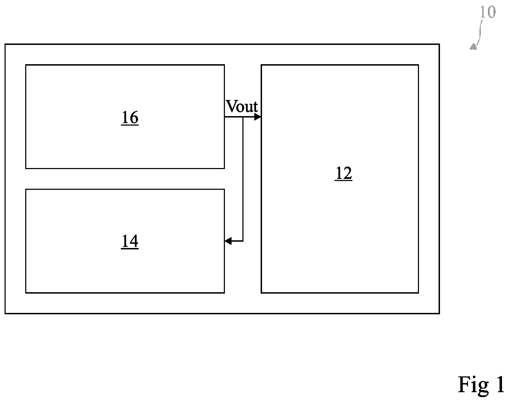

La figure 1 représente un exemple de dispositif électronique 10. Le dispositif 10 est par exemple une puce.

Le dispositif 10 comprend par exemple un ensemble 12 de circuits et de composants configurée pour permettre la mise en œuvre de fonctions numériques. L'ensemble 12 comprend par exemple un ou plusieurs microcontrôleurs. Le dispositif 10 comprend par exemple une mémoire 14.

Le dispositif 10 comprend une unité 16 de gestion de la puissance. L'unité 16 est par exemple configurée pour générer une tension d'alimentation Vout. La tension d'alimentation Vout est par exemple la tension d'alimentation de l'ensemble 12 et/ou de la mémoire 14.

L'unité 16 comprend par exemple au moins un régulateur de tension, ou un suiveur de tension, configuré pour permettre de maintenir la tension Vout à une valeur voulue lors du fonctionnement du dispositif 10.

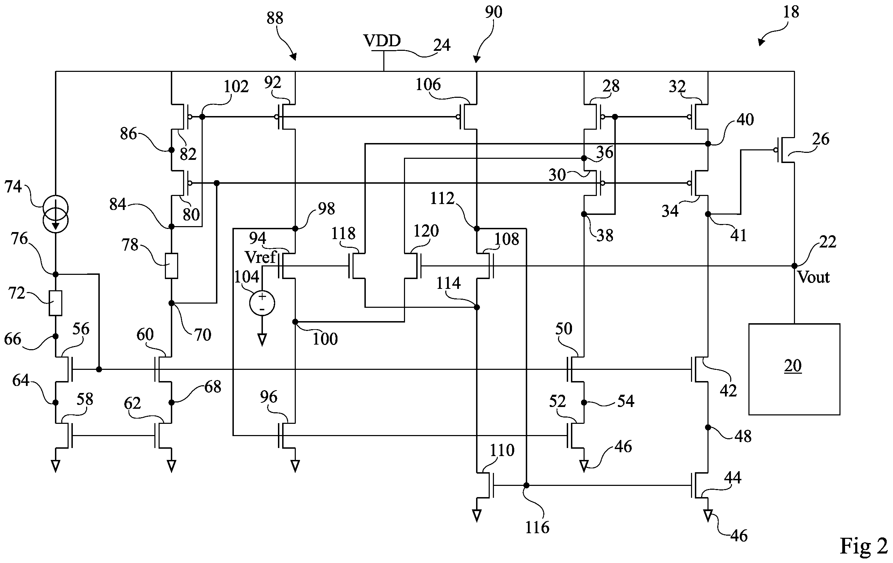

La figure 2 représente un mode de réalisation d'un régulateur de tension 18. Le régulateur de tension 18 est par exemple configuré pour être compris dans l'unité 16 de gestion de puissance de la figure 1.

Le régulateur de tension 18 est configuré pour alimenter une charge 20. La charge 20 correspond par exemple à la mémoire 14 ou à l'ensemble 12 de la figure 1. Plus précisément, le régulateur 18 comprend un noeud de sortie 22 sur lequel est généré la tension d'alimentation Vout. La charge 20 est reliée, de préférence connectée, au noeud 22.

Le régulateur 18 comprend un transistor 26. Le transistor 26 est par exemple un transistor à effet de champ à grille isolée (MOSFET - Métal Oxide Semiconductor Field Effect Transistor). Le transistor 26 est de préférence un transistor à canal P.

Le noeud 22 est relié à un noeud 24 d'application d'une tension VDD d'alimentation du dispositif 10, c'est-à-dire une tension d'alimentation du régulateur 18, par le transistor 26. Autrement dit, un noeud de conduction du transistor 26, par exemple la source, est relié, de préférence connecté, au noeud 24 et un autre noeud de conduction du transistor 26, par exemple le drain, est relié, de préférence connecté, au noeud 22.

Le régulateur 18 comprend en outre des transistors 28, 30, 32, 34. Les transistors 28, 30, 32, 34 sont par exemple des transistors à effet de champ à grille isolée (MOSFET). Les transistors 28, 30, 32, 34 sont de préférence des transistors à canal P.

Les transistors 28 et 30 sont reliés en série. De même, les transistors 32 et 34 sont reliés en série. Les transistors 28 et 30 sont reliés en cascode. Autrement dit, un noeud de conduction du transistor 28, de préférence la source, est relié, de préférence connecté, au noeud 24. Un autre noeud de conduction du transistor 28, par exemple le drain, est relié, de préférence connecté, à un noeud 36. Un noeud de conduction du transistor 30, de préférence la source, est relié, de préférence connecté, au noeud 36. Un autre noeud de conduction du transistor 30, par exemple le drain, est relié, de préférence connecté, à un noeud 38. Le noeud de commande du transistor 28, par exemple la grille, est reliée, de préférence connectée, au noeud 38.

En outre, les transistors 32 et 34 sont reliés en miroir de courant avec les transistors 28 et 30. Autrement dit, un noeud de conduction du transistor 32, de préférence la source, est relié, de préférence connecté, au noeud 24. Un autre noeud de conduction du transistor 32, par exemple le drain, est relié, de préférence connecté, à un noeud 40. Un noeud de conduction du transistor 34, de préférence la source, est reliée, de préférence connectée, au noeud 40. Un autre noeud de conduction du transistor 34, par exemple le drain, est relié, de préférence connecté, à un noeud 41. Le noeud de commande du transistor 32, par exemple la grille, est relié, de préférence connecté, au noeud de commande du transistor 28. Ainsi, le noeud de commande du transistor 32 est relié, de préférence connecté, au noeud 38. Le noeud de commande, par exemple la grille, du transistor 34 est relié, de préférence connecté, au noeud de commande du transistor 30.

Le noeud de commande du transistor 26, par exemple la grille, est relié, de préférence connecté, au noeud 41.

Le régulateur 18 comprend en outre des transistors 42 et 44. Les transistors 42 et 44 sont par exemple des transistors à effet de champ à grille isolée (MOSFET). Les transistors 42 et 44 sont de préférence des transistors à canal N.

Les transistors 42 et 44 sont reliés en série. Les transistors 42 et 44 sont, en outre, relié en série avec les transistors 32 et 34. Autrement dit, un noeud de conduction du transistor 44, de préférence la source, est relié, de préférence connecté, à un noeud 46 d'application d'une tension de référence, par exemple la masse. Un autre noeud de conduction du transistor 44, par exemple le drain, est relié, de préférence connecté, à un noeud 48. Un noeud de conduction du transistor 42, de préférence la source, est relié, de préférence connecté, au noeud 48. Un autre noeud de conduction du transistor 42, par exemple le drain, est relié, de préférence connecté, au noeud 41.

Similairement, le régulateur 18 comprend en outre des transistors 50 et 52. Les transistors 50 et 52 sont par exemple des transistors à effet de champ à grille isolée (MOSFET). Les transistors 50 et 52 sont de préférence des transistors à canal N.

Les transistors 50 et 52 sont reliés en série. Les transistors 50 et 52 sont, en outre, relié en série avec les transistors 28, 30. Autrement dit, un noeud de conduction du transistor 52, de préférence la source, est relié, de préférence connecté, au noeud 46 d'application d'une tension de référence, par exemple la masse. Un autre noeud de conduction du transistor 52, par exemple le drain, est relié, de préférence connecté, à un noeud 54. Un noeud de conduction du transistor 50, de préférence la source, est relié, de préférence connecté, au noeud 54. Un autre noeud de conduction du transistor 50, par exemple le drain, est relié, de préférence connecté, au noeud 38.

Le régulateur 18 comprend en outre des transistors 56, 58, 60, 62. Les transistors 56, 58, 60, 62 sont par exemple des transistors à effet de champ à grille isolée (MOSFET). Les transistors 56, 58, 60, 62 sont de préférence des transistors à canal N.

Les transistors 56, 58 sont reliés en série. De même, les transistors 60, 62 sont reliés en série. Les transistors 56, 58 sont reliés en cascode. Autrement dit, un noeud de conduction du transistor 58, de préférence la source, est relié, de préférence connecté, au noeud 46. Un autre noeud de conduction du transistor 58, par exemple le drain, est relié, de préférence connecté, à un noeud 64. Un noeud de conduction du transistor 56, de préférence la source, est relié, de préférence connecté, au noeud 64. Un autre noeud de conduction du transistor 56, par exemple le drain, est relié, de préférence connecté, à un noeud 66.

En outre, les transistors 60 et 62 sont reliés en miroir de courant avec les transistors 56, 58. Autrement dit, un noeud de conduction du transistor 62, de préférence la source, est relié, de préférence connecté, au noeud 46. Un autre noeud de conduction du transistor 62, par exemple le drain, est relié, de préférence connecté, à un noeud 68. Un noeud de conduction du transistor 60, de préférence la source, est reliée, de préférence connectée, au noeud 68. Un autre noeud de conduction du transistor 60, par exemple le drain, est relié, de préférence connecté, à un noeud 70. Le noeud de commande du transistor 62, par exemple la grille, est relié, de préférence connecté, au noeud de commande, par exemple la grille, du transistor 58. Le noeud de commande, par exemple la grille, du transistor 60 est relié, de préférence connecté, au noeud de commande, par exemple la grille, du transistor 56. En outre, le noeud de commande du transistor 60 est relié, de préférence connecté, au noeud de commande du transistor 50 et au noeud de commande du transistor 42. Autrement dit, les noeuds de commande des transistors 42, 50, 56, 60 sont reliés, de préférence connectés, entre eux.

Le régulateur 18 comprend en outre une résistance 72 et une source de courant 74. La résistance 72 et la source 74 sont reliées en série. La résistance 72 et la source 74 sont reliées en série avec les transistors 56 et 58. Autrement dit, une borne de la résistance 72 est reliée, de préférence connectée, au noeud 66 et une autre borne de la résistance 72 est reliée, de préférence connectée, à un noeud 76. Le noeud 76 est en outre relié, de préférence connecté, au noeud de commande du transistor 56. Le noeud 76 est ainsi relié, de préférence connecté, au noeud de commande du transistor 60. La source 74 comprend une borne reliée, de préférence connectée, au noeud 76 et une autre borne reliée, de préférence connectée, au noeud 24.

Le régulateur 18 comprend une résistance 78 et des transistors 80 et 82. Les transistors 80 et 82 sont par exemple des transistors à effet de champ à grille isolée (MOSFET). Les transistors 80 et 82 sont de préférence des transistors à canal P.

Les transistors 80, 82 et la résistance 78 sont reliés en série. Les transistors 80, 82 et la résistance 78 sont reliés en série avec les transistors 60 et 62. Autrement dit, une borne de la résistance 78 est reliée, de préférence connectée, au noeud 70 et une autre borne de la résistance 78 est reliée, de préférence connectée, à un noeud 84. Un noeud de conduction du transistor 80, de préférence la source, est relié, de préférence connecté, au noeud 24. Un autre noeud de conduction du transistor 62, par exemple le drain, est relié, de préférence connecté, à un noeud 86. Un noeud de conduction du transistor 80, de préférence la source, est reliée, de préférence connectée, au noeud 86. Un autre noeud de conduction du transistor 82, par exemple le drain, est relié, de préférence connecté, au noeud 84. Le noeud de commande du transistor 80 est relié, de préférence connecté, au noeud 70. En outre, le noeud de commande du transistor 80 est relié, de préférence connecté, au noeud de commande du transistor 30 et au noeud de commande du transistor 34. Ainsi, les noeuds de commande des transistors 30, 34 et 80 sont par exemple reliés, de préférence connectés, ensemble. De plus, le noeud de commande du transistor 82 est relié, de préférence connecté, au noeud 84.

Le régulateur 18 comprend en outre deux branches 88 et 92. Les branches 88 et 90 comprennent toutes deux trois transistors reliés en série entre les noeuds 24 et 46.

Ainsi, la branche 88 comprend des transistors 92, 94, 96. Les transistors 92, 94, 96 sont par exemple des transistors à effet de champ à grille isolée (MOSFET). Les transistors 94, 96 sont de préférence des transistors à canal N. Le transistor 92 est par exemple un transistor à canal P. Le transistor 96 est par exemple un transistor identique au transistor 52. Alternativement, la surface du transistor 96 a par exemple une surface sensiblement égale à un multiple de la surface du transistor 52.

Les transistors 92, 94, 96 sont reliés en série entre les noeud 24 et 46. Autrement dit, le transistor 92 comprend un noeud de conduction, par exemple la source, relié, de préférence connecté, au noeud 24. Un autre noeud de conduction du transistor 92, par exemple le drain, est relié, de préférence connecté, à un noeud 98. Le transistor 94 comprend un noeud de conduction, par exemple la source, relié, de préférence connecté, au noeud 98. Un autre noeud de conduction du transistor 94, par exemple le drain, est relié, de préférence connecté, à un noeud 100. Le transistor 96 comprend un noeud de conduction, par exemple le drain, relié, de préférence connecté, au noeud 100. Un autre noeud de conduction du transistor 96, par exemple la source, est relié, de préférence connecté, au noeud 46.

Le transistor 92 comprend un noeud de commande, par exemple la grille, relié, de préférence connecté, à un noeud 102. Le noeud 102 est relié, de préférence connecté, au noeud de commande du transistor 82 et est relié, de préférence connecté, au noeud 84. Le transistor 94 comprend un noeud de commande, par exemple la grille, relié, de préférence connecté, à une borne, par exemple une borne positive, d'une source de tension 104. La source de tension 104 est configurée pour générer sur la borne positive, une tension de consigne Vref. La source 104 comprend en outre une borne, par exemple une borne négative, reliée, de préférence connectée, au noeud 46. Le transistor 96 comprend un noeud de commande, par exemple la grille, relié, de préférence connecté, au noeud 98, c'est-à-dire relié, de préférence connecté, à la source du transistor 94, c'est-à-dire relié, de préférence connecté, au point milieu des transistors 92 et 94.

Similairement, la branche 90 comprend des transistors 106, 108, 110. Les transistors 106, 108, 110 sont par exemple des transistors à effet de champ à grille isolée (MOSFET). Les transistors 108, 110 sont de préférence des transistors à canal N. Le transistor 106 est par exemple un transistor à canal P. Le transistor 110 est par exemple un transistor identique au transistor 44. Alternativement, la surface du transistor 110 a par exemple une surface sensiblement égale à un multiple de la surface du transistor 44.

Les transistors 106, 108, 110 sont reliés en série entre les noeud 24 et 46. Autrement dit, le transistor 106 comprend un noeud de conduction, par exemple la source, relié, de préférence connecté, au noeud 24. Un autre noeud de conduction du transistor 106, par exemple le drain, est relié, de préférence connecté, à un noeud 112. Le transistor 108 comprend un noeud de conduction, par exemple la source, relié, de préférence connecté, au noeud 112. Un autre noeud de conduction du transistor 108, par exemple le drain, est relié, de préférence connecté, à un noeud 114. Le transistor 110 comprend un noeud de conduction, par exemple le drain, relié, de préférence connecté, au noeud 114. Un autre noeud de conduction du transistor 110, par exemple la source, est relié, de préférence connecté, au noeud 46.

Le transistor 106 comprend un noeud de commande, par exemple la grille, relié, de préférence connecté, au noeud 102. Le noeud 102 est relié, de préférence connecté, aux noeuds de commande des transistors 82 et 92 et est relié, de préférence connecté, au noeud 84. Le transistor 108 comprend un noeud de commande, par exemple la grille, relié, de préférence connecté, au noeud de sortie 22, sur lequel est généré la tension Vout. Le transistor 110 comprend un noeud de commande, par exemple la grille, relié, de préférence connecté, à un noeud 116, c'est-à-dire relié, de préférence connecté, à la source du transistor 108, c'est-à-dire relié, de préférence connecté, au point milieu des transistors 106 et 108. Le noeud 116 est en outre relié, de préférence connecté, au noeud de commande du transistor 44.

Le régulateur 18 comprend en outre une paire de transistors différentiels 118, 120. Les transistors 118, 120 sont par exemple des transistors à effet de champ à grille isolée (MOSFET). Les transistors 118, 120 sont de préférence des transistors à canal N. De préférence, les transistors 118 et 120 sont des transistors identiques. Alternativement, un des transistors 118, 120 peut avoir une surface sensiblement égale à un multiple de la surface de l'autre transistor parmi les transistors 118, 120.

Le transistor 118 est relié entre le noeud 114, c'est-à-dire le noeud milieu des transistors 108 et 110, et le noeud 40, c'est-à-dire le point milieu des transistors 32 et 34. Autrement dit, un noeud de conduction du transistor 118, par exemple la source, est relié, de préférence connecté, au noeud 114. Un autre noeud de conduction du transistor 118, par exemple le drain, est relié, de préférence connecté, au noeud 40. Un noeud de commande, par exemple la grille, du transistor 118 est relié, de préférence connecté, au noeud de commande du transistor 94 et à la borne positive de la source 104.

Le transistor 120 est relié entre le noeud 100, c'est-à-dire le noeud milieu des transistors 94 et 96, et le noeud 36, c'est-à-dire le point milieu des transistors 28 et 36. Autrement dit, un noeud de conduction du transistor 120, par exemple la source, est relié, de préférence connecté, au noeud 100. Un autre noeud de conduction du transistor 120, par exemple le drain, est relié, de préférence connecté, au noeud 36. Un noeud de commande, par exemple la grille, du transistor 120 est relié, de préférence connecté, au noeud de commande du transistor 108 et au noeud 22.

Lorsqu'un courant est tiré par la charge, la tension Vout varie. Cette variation de la tension Vout entraine une variation des courants traversant les transistors 32, 34 et une variation des transistors 42, 44. La variation de la tension Vout n'entraine pas uniquement une variation des courants traversant les transistors 32, 34, comme dans les régulateurs couramment utilisés. Le courant au niveau du noeud 41, c'est-à-dire le courant de commande du transistor 26, varie ainsi plus rapidement dans le régulateur 18, ce qui entraine une régulation de la tension Vout plus rapide.

Le bias appliqué aux transistors 118 et 120 de la paire différentielle est ainsi dynamique.

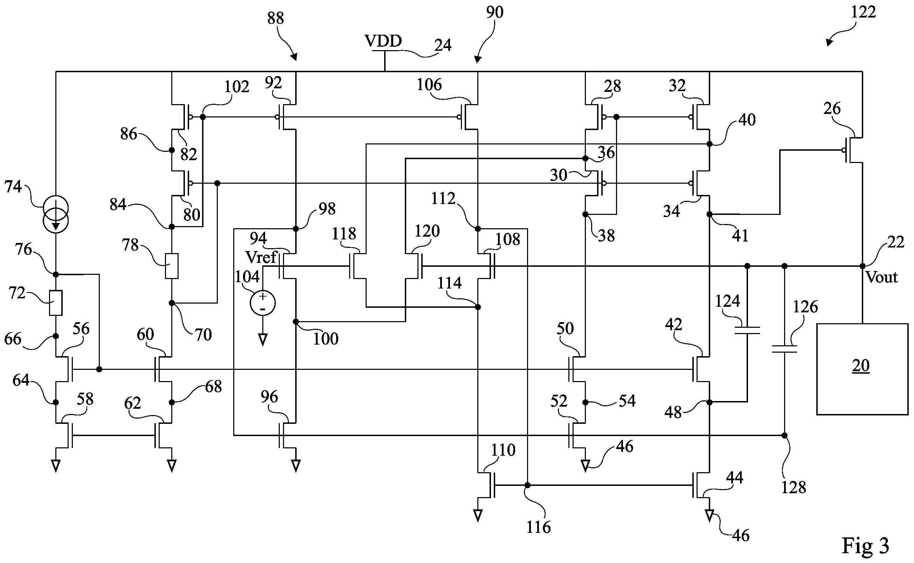

La figure 3 représente un autre mode de réalisation d'un régulateur de tension 122.

Le régulateur 122 comprend les composants du régulateur 18 de la figure 2, agencés de manière identique. Ces différents composants, c'est-à-dire les transistors 26, 32, 34, 42, 44, 28, 30, 50, 52, 106, 108, 110, 118, 120, 92, 94, 96, 82, 80, 60, 62, 56, 58, les résistances 72 et 78 et les sources 74 et 104, sont ainsi présents dans le régulateur 122 et ne seront pas décrits de nouveau en détail.

Le régulateur 122 comprend en outre des condensateurs 124 et 126. Les condensateurs 124 et 126 sont des condensateurs de Miller et permettent ainsi de compenser le gain de la boucle et accélérer la réponse du régulateur.

Le condensateur 124 est relié entre le noeud de sortie 22 et le noeud 48, c'est-à-dire le noeud milieu des transistors 42 et 44. Autrement dit, une borne du condensateur 124 est reliée, de préférence connectée, au noeud 22 et une autre borne du condensateur 124 est reliée, de préférence connectée, au noeud 48.

Le condensateur 126 est relié entre le noeud de sortie 22 et un noeud 128. Autrement dit, une borne du condensateur 126 est reliée, de préférence connectée, au noeud 22 et une autre borne du condensateur 126 est reliée, de préférence connectée, au noeud 128. Le noeud 128 est en outre relié, de préférence connecté, aux noeuds de commande des transistors 52 et 96.

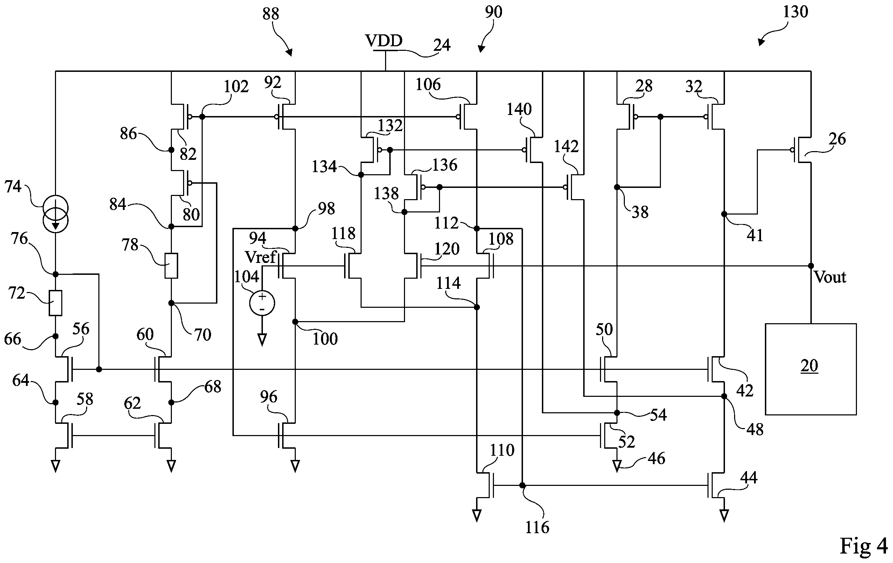

La figure 4 représente un autre mode de réalisation d'un régulateur de tension 130.

Le régulateur 130 comprend les composants du régulateur 18 de la figure 2, agencés de manière identiques, à l'exception des transistors 30 et 34. Ces différents composants, c'est-à-dire les transistors 26, 32, 42, 44, 28, 50, 52, 106, 108, 110, 118, 120, 92, 94, 96, 82, 80, 60, 62, 56, 58, les résistances 72 et 78 et les sources 74 et 104, sont ainsi présents dans le régulateur 130 et ne seront pas décrits de nouveau en détail. En l'absence des transistors 30 et 34, un noeud de conduction du transistor 28, par exemple le drain, est relié, de préférence connecté, au noeud 38 et un noeud de conduction du transistor 32, par exemple le drain, est relié, de préférence connecté, au noeud 41. Ainsi, le noeud de commande du transistor 28 est relié, de préférence connecté, au drain du transistor 28. De plus, le noeud de commande du transistor 26 est relié, de préférence connecté, au drain du transistor 32.

Contrairement au régulateur 18, le transistor 118 n'est pas relié entre le noeud 40 et le noeud 114. De même, le transistor 120 n'est pas relié entre le noeud 36 et le noeud 100. Le transistor 118 est relié en série avec un transistor 132, différent du transistor 32, entre les noeuds 114 et 24. Similairement, le transistor 120 est relié en série avec un transistor 136, différent du transistor 28, entre les noeuds 100 et 24.

Les transistors 132 et 136 sont par exemple des transistors à effet de champ à grille isolée (MOSFET). Les transistors 132 et 136 sont de préférence des transistors à canal P.

Autrement dit, un noeud de conduction, par exemple la source, du transistor 118 est, comme en figure 2, relié, de préférence connecté, au noeud 114 et un autre noeud de conduction du transistor 118 est relié, de préférence connecté, à un noeud 134. Un noeud de conduction du transistor 132, par exemple la source, est relié, de préférence connecté, au noeud 24 et un autre noeud de conduction du transistor 132, par exemple le drain, est relié, de préférence connecté, au noeud 134. Le noeud de commande du transistor 132, par exemple la grille, est relié, de préférence connecté, au noeud 134.

De plus, un noeud de conduction, par exemple la source, du transistor 120 est, comme en figure 2, relié, de préférence connecté, au noeud 100 et un autre noeud de conduction du transistor 120 est relié, de préférence connecté, à un noeud 138. Un noeud de conduction du transistor 136, par exemple la source, est relié, de préférence connecté, au noeud 24 et un autre noeud de conduction du transistor 136, par exemple le drain, est relié, de préférence connecté, au noeud 138. Le noeud de commande du transistor 136, par exemple la grille, est relié, de préférence connecté, au noeud 138.

Le régulateur 130 comprend en outre des transistors 140 et 142. Les transistors 140 et 142 sont par exemple des transistors à effet de champ à grille isolée (MOSFET). Les transistors 140 et 142 sont de préférence des transistors à canal P.

Le transistor 140 est relié entre le noeud 24 et le noeud 54. Autrement dit, un noeud de conduction du transistor 140, par exemple la source, est relié, de préférence connecté, au noeud 24 et un autre noeud de conduction du transistor 140, par exemple le drain, est relié, de préférence connecté, au noeud 54.

Similairement, le transistor 142 est relié entre le noeud 24 et le noeud 48. Autrement dit, un noeud de conduction du transistor 142, par exemple la source, est relié, de préférence connecté, au noeud 24 et un autre noeud de conduction du transistor 142, par exemple le drain, est relié, de préférence connecté, au noeud 48.

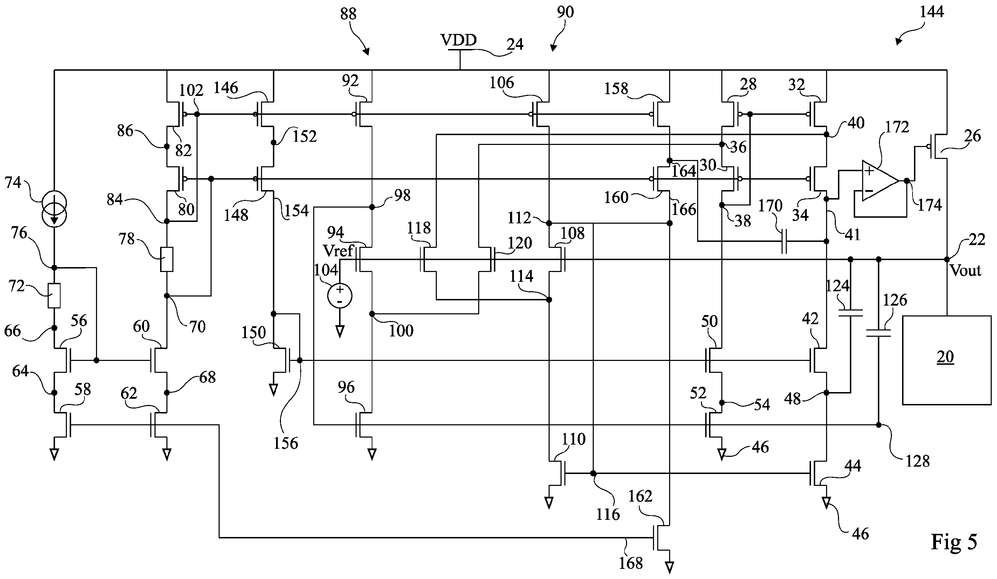

La figure 5 représente un autre mode de réalisation d'un régulateur de tension 144.

Le régulateur 144 comprend les composants du régulateur 122 de la figure 3, agencés de manière identiques. Ces différents composants, c'est-à-dire les transistors 26, 28, 30, 32, 34, 42, 44, 50, 52, 56, 58, 60, 62, 80, 82, 92, 94, 96, 106, 108, 110, 118, 120, les résistances 72 et 78, les condensateurs 124, 126 et les sources 74 et 104, sont ainsi présents dans le régulateur 144 et ne seront pas décrits de nouveau en détail. Le régulateur 144 diffère du régulateur 122 de la figure 3 en ce que le noeud de commande du transistor 60 n'est pas, comme en figure 3 relié aux noeuds de commande des transistors 42 et 50.

Le régulateur 144 comprend des transistors 146, 148, 150. Les transistors 146, 148, 150 sont par exemple des transistors à effet de champ à grille isolée (MOSFET). Les transistors 146, 148 sont de préférence des transistors à canal P. Le transistor 150 est par exemple un transistor à canal N.

Les transistors 146, 148, 150 sont reliés en série entre les noeud 24 et 46. Autrement dit, le transistor 146 comprend un noeud de conduction, par exemple la source, relié, de préférence connecté, au noeud 24. Un autre noeud de conduction du transistor 146, par exemple le drain, est relié, de préférence connecté, à un noeud 152. Le transistor 148 comprend un noeud de conduction, par exemple la source, relié, de préférence connecté, au noeud 152. Un autre noeud de conduction du transistor 148, par exemple le drain, est relié, de préférence connecté, à un noeud 154. Le transistor 150 comprend un noeud de conduction, par exemple le drain, relié, de préférence connecté, au noeud 154. Un autre noeud de conduction du transistor 150, par exemple la source, est relié, de préférence connecté, au noeud 46.

Le transistor 146 comprend un noeud de commande, par exemple la grille, relié, de préférence connecté, au noeud 102. Le noeud 102 est relié, de préférence connecté, aux noeuds de commande des transistors 82, 92 et 106 et est relié, de préférence connecté, au noeud 84. Le transistor 148 comprend un noeud de commande, par exemple la grille, relié, de préférence connecté, au noeud 70. Le noeud 70 est relié, de préférence connecté, aux noeuds de commande des transistors 80, 30 et 34. Le transistor 150 comprend un noeud de commande, par exemple la grille, relié, de préférence connecté, à un noeud 156. Le noeud 156 est relié, de préférence connecté, au noeud de commande des transistors 42 et 50. Le noeud 156 est en outre relié, de préférence connecté, au noeud 154.

Le régulateur 144 comprend des transistors 158, 160, 162. Les transistors 158, 160, 162 sont par exemple des transistors à effet de champ à grille isolée (MOSFET). Les transistors 158, 160 sont de préférence des transistors à canal P. Le transistor 162 est par exemple un transistor à canal N.

Les transistors 158, 160, 162 sont reliés en série entre les noeud 24 et 46. Autrement dit, le transistor 158 comprend un noeud de conduction, par exemple la source, relié, de préférence connecté, au noeud 24. Un autre noeud de conduction du transistor 158, par exemple le drain, est relié, de préférence connecté, à un noeud 164. Le transistor 160 comprend un noeud de conduction, par exemple la source, relié, de préférence connecté, au noeud 164. Un autre noeud de conduction du transistor 160, par exemple le drain, est relié, de préférence connecté, à un noeud 166. Le transistor 162 comprend un noeud de conduction, par exemple le drain, relié, de préférence connecté, au noeud 166. Un autre noeud de conduction du transistor 162, par exemple la source, est relié, de préférence connecté, au noeud 46.

Le transistor 158 comprend un noeud de commande, par exemple la grille, relié, de préférence connecté, au noeud 102. Le noeud 102 est relié, de préférence connecté, aux noeuds de commande des transistors 82, 92, 106 et 146 et est relié, de préférence connecté, au noeud 84. Le transistor 160 comprend un noeud de commande, par exemple la grille, relié, de préférence connecté, au noeud 70. Le noeud 70 est relié, de préférence connecté, aux noeuds de commande des transistors 80, 30, 34 et 148. Le transistor 162 comprend un noeud de commande, par exemple la grille, relié, de préférence connecté, à un noeud 168. Le noeud 168 est relié, de préférence connecté, au noeud de commande des transistors 58 et 62.

Le régulateur 144 comprend en outre un condensateur 170. Le condensateur 170 est relié entre le noeud 41 et le noeud 1644. Ainsi, une borne du condensateur 170 est reliée, de préférence connectée, au noeud 41, c'est-à-dire le point milieu des transistor 34 et 42 et une autre borne du condensateur 170 est reliée, de préférence connectée, au noeud 164, c'est-à-dire le point milieu des transistors 158 et 160.

Le régulateur 144 comprend en outre un circuit tampon 172. Dans l'exemple de la figure 5, le circuit 172 est un amplificateur opérationnel.

Le circuit 172 comprend une première entrée, par exemple l'entrée non inverseuse (+), et une deuxième entrée, par exemple l'entrée inverseuse (-). La première entrée est reliée, de préférence connectée, au noeud 41. La deuxième entrée est reliée, de préférence connectée, à un noeud 174.

Le circuit 172 comprend une sortie. Ladite sortie est reliée, de préférence connectée, au noeud 174. Le noeud 174 est en outre relié, de préférence connecté, au noeud de commande du transistor 26. Ainsi, la deuxième entrée et la sortie du circuit 172 sont reliées, de préférence connectées, au noeud de commande du transistor 26.

Le condensateur 170 permet d'améliorer la stabilité du régulateur. Plus précisément, le condensateur 170 diminue la fréquence de la branche 90 et évite les surtensions. Le circuit 172 permet d'obtenir une réponse transitoire de charge très rapide.

Selon un autre mode de réalisation, le régulateur 144 peut comprendre une résistance, non représentée, reliée en série avec le condensateur 170 entre les noeuds 41 et 164.

Les transistors 158, 160, 162 permettent de maintenir une réponse transitoire de ligne rapide.

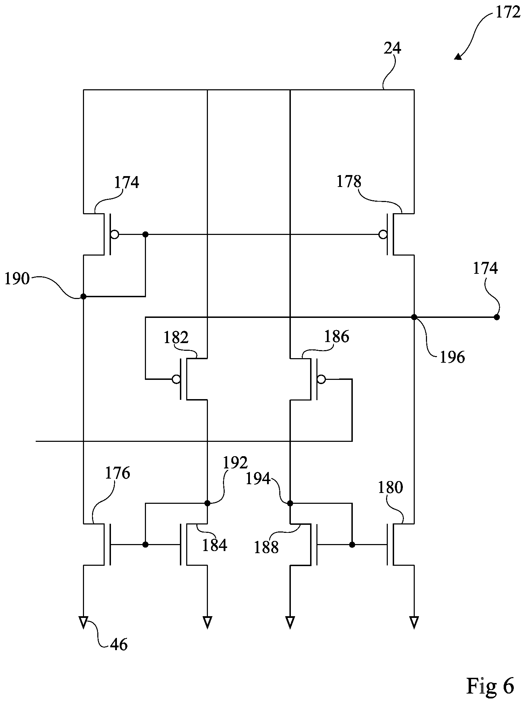

La figure 6 représente une variante d'une partie du mode de réalisation de la figure 1. Plus précisément, la figure 6 illustre un exemple d'implémentation du circuit 172.

Le circuit 172 comprend des transistors 174, 176, 178, 180, 182, 184, 186, 188. Les transistors transistors 174, 176, 178, 180, 182, 184, 186, 188 sont par exemple des transistors à effet de champ à grille isolée (MOSFET). Les transistors 174, 178, 182, 186 sont de préférence des transistors à canal P. Les transistors 176, 180, 184, 188 sont par exemple des transistors à canal N.

Les transistors 174 et 176 sont reliés en série entre les noeuds 24 et 46. Autrement dit, le transistor 174 comprend un noeud de conduction, par exemple la source, relié, de préférence connecté, au noeud 24. Un autre noeud de conduction du transistor 174, par exemple le drain, est relié, de préférence connecté, à un noeud 190. Le transistor 176 comprend un noeud de conduction, par exemple la source, relié, de préférence connecté, au noeud 190. Un autre noeud de conduction du transistor 176, par exemple le drain, est relié, de préférence connecté, au noeud 46.

Similairement, les transistors 182 et 184 sont reliés en série entre les noeuds 24 et 46. Autrement dit, le transistor 182 comprend un noeud de conduction, par exemple la source, relié, de préférence connecté, au noeud 24. Un autre noeud de conduction du transistor 182, par exemple le drain, est relié, de préférence connecté, à un noeud 192. Le transistor 184 comprend un noeud de conduction, par exemple la source, relié, de préférence connecté, au noeud 192. Un autre noeud de conduction du transistor 184, par exemple le drain, est relié, de préférence connecté, au noeud 46.

Similairement, les transistors 186 et 188 sont reliés en série entre les noeuds 24 et 46. Autrement dit, le transistor 186 comprend un noeud de conduction, par exemple la source, relié, de préférence connecté, au noeud 24. Un autre noeud de conduction du transistor 186, par exemple le drain, est relié, de préférence connecté, à un noeud 194. Le transistor 188 comprend un noeud de conduction, par exemple la source, relié, de préférence connecté, au noeud 194. Un autre noeud de conduction du transistor 188, par exemple le drain, est relié, de préférence connecté, au noeud 46.

Similairement, les transistors 178 et 180 sont reliés en série entre les noeuds 24 et 46. Autrement dit, le transistor 178 comprend un noeud de conduction, par exemple la source, relié, de préférence connecté, au noeud 24. Un autre noeud de conduction du transistor 178, par exemple le drain, est relié, de préférence connecté, à un noeud 196. Le transistor 180 comprend un noeud de conduction, par exemple la source, relié, de préférence connecté, au noeud 196. Un autre noeud de conduction du transistor 180, par exemple le drain, est relié, de préférence connecté, au noeud 46.

Le transistor 174 comprend un noeud de commande, par exemple la grille, relié, de préférence connecté, au noeud 190. Le noeud 190 est en outre relié, de préférence connecté, au noeud de commande du transistor 178. Le transistor 176 comprend un noeud de commande, par exemple la grille, relié, de préférence connecté, au noeud 192. Le noeud 192 est en outre relié, de préférence connecté, au noeud de commande du transistor 184. Le transistor 182 comprend un noeud de commande, par exemple la grille, relié, de préférence connecté, au noeud 196. Le noeud 196 est en outre relié, de préférence connecté, au noeud 174 et donc à la sortie du circuit 172. Le noeud 196 est en outre relié à l'entrée inverseuse du circuit 172. Le transistor 180 comprend un noeud de commande, par exemple la grille, relié, de préférence connecté, au noeud 194. Le noeud 194 est en outre relié, de préférence connecté, au noeud de commande du transistor 188. Le transistor 186 comprend un noeud de commande, par exemple la grille, relié, de préférence connecté, à l'entrée non inverseuse du circuit 172 et donc au noeud 41.

Le circuit 172 décrit en relation avec la figure 6 permet d'assurer un biais adaptatif au niveau du courant de charge. Cela permet en outre d'améliorer la réponse transitoire quand le courant de charge augmente.

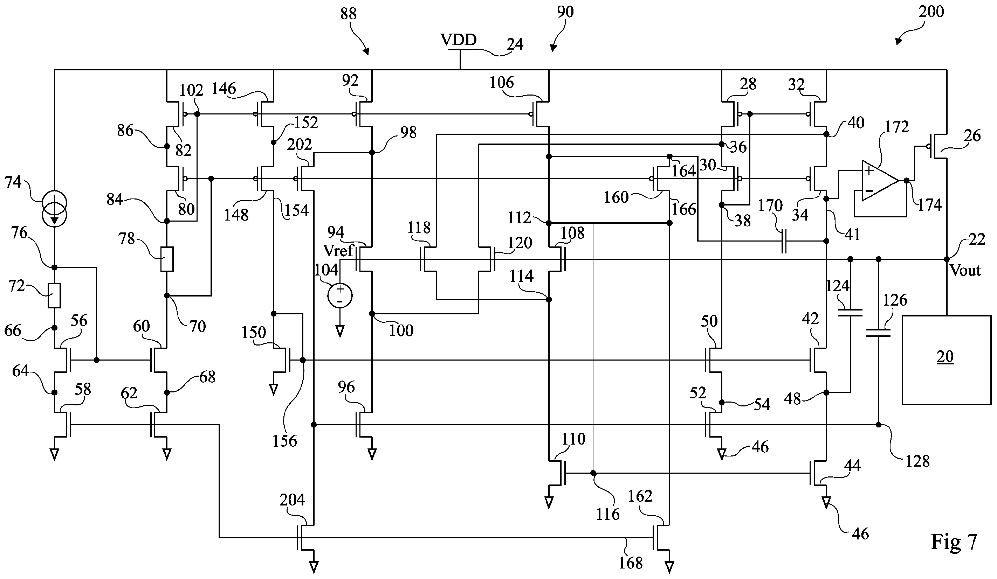

La figure 7 représente un autre mode de réalisation d'un régulateur de tension 200.

Le régulateur 200 comprend les composants du régulateur 144 de la figure 5, agencés de manière identiques. Ces différents composants, c'est-à-dire les transistors 26, 28, 30, 32, 34, 42, 44, 50, 52, 56, 58, 60, 62, 80, 82, 92, 94, 96, 106, 108, 110, 118, 120, 146, 148, 150, 160, 162, les résistances 72 et 78, le circuit 172, les condensateurs 124, 126, 170 et les sources 74 et 104, sont ainsi présents dans le régulateur 122 et ne seront pas décrits de nouveau en détail.

Le régulateur 200 diffère du régulateur 144 en ce que le régulateur 200 ne comprend pas le transistor 158. Le noeud 164 est alors relié, de préférence connecté, au noeud 112, c'est-à-dire le point milieu des transistors 106 et 108.

Le régulateur 144 comprend des transistors 202 et 204. Les transistors 202 et 204 sont par exemple des transistors à effet de champ à grille isolée (MOSFET). Le transistor 202 est de préférence un transistor à canal P. Le transistor 204 est par exemple un transistor à canal N.

Les transistors 202 et 204 sont reliés en série avec le transistor 92 entre les noeud 24 et 46. Autrement dit, le transistor 92 comprend un noeud de conduction, par exemple la source, relié, de préférence connecté, au noeud 24. Un autre noeud de conduction du transistor 92, par exemple le drain, est relié, de préférence connecté, au noeud 98. Le transistor 202 comprend un noeud de conduction, par exemple la source, relié, de préférence connecté, au noeud 98. Un autre noeud de conduction du transistor 202, par exemple le drain, est relié, de préférence connecté, au noeud 128, et donc aux noeuds de commande des transistors 96 et 52. Le transistor 204 comprend un noeud de conduction, par exemple le drain, relié, de préférence connecté, au noeud 128. Un autre noeud de conduction du transistor 204, par exemple la source, est relié, de préférence connecté, au noeud 46.

Le transistor 202 comprend un noeud de commande, par exemple la grille, relié, de préférence connecté, au noeud 70. Le noeud 70 est relié, de préférence connecté, aux noeuds de commande des transistors 80, 148, 160, 30 et 34. Le transistor 204 comprend un noeud de commande, par exemple la grille, relié, de préférence connecté, à un noeud 168. Le noeud 168 est relié, de préférence connecté, au noeud de commande des transistors 62, 64, 162.

L'ajout des transistors 2020 et 204 permet d'égaliser les tensions de drains des paires différentielles, c'est-à-dire des transistors 94 et 118 et des transistors 120 et 108.

Le circuit 172 est par exemple implémenté comme décrit en relation avec la figure 6.

Un avantage des modes de réalisation décrits est qu'ils permettent d'appliquer un biais variable aux deux bornes de conduction des transistors de la paire différentielle. Ainsi, la réponse du régulateur de courant est plus rapide en cas de variation sur le noeud de sortie.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les condensateurs de Miller 124 et 126 peuvent être présents, agencés aux mêmes emplacements que dans le mode de réalisation de la figure 3, dans le mode de réalisation de la figure 4.

Enfin, la mise en oeuvre pratique des modes de réalisation et variantes décrits est à la portée de la personne du métier à partir des indications fonctionnelles données ci-dessus.

## Revendications

1. Dispositif comprenant un régulateur de tension (18, 122, 130), le régulateur comprenant :
des première (88) et deuxième (90) branches, chaque première (88) et deuxième (90) branche comprenant des premier (92, 106), deuxième (94, 108) et troisième (96, 110) transistors reliés en série, dans cet ordre, entre un premier noeud (24) d'application d'une tension d'alimentation (VDD) et un deuxième noeud (46) d'application d'une tension de référence, les noeuds de commande des premiers transistors (92, 106) des première (88) et deuxième (90) branches étant reliés ensemble, le noeud de commande du troisième transistor (96, 110) de chaque première (88) et deuxième (90) branche étant relié au point milieu des premier (92, 106) et deuxième (94, 108) transistors de la même branche ;
un quatrième transistor (118) relié entre le point milieu (44) des deuxième (108) et troisième (110) transistors de la deuxième branche (90) et un troisième noeud (40) ; et
un cinquième transistor (120) relié entre le point milieu (100) des deuxième (94) et troisième (108) transistors de la première branche (88) et un quatrième noeud (36),
les noeuds de commande du quatrième transistor (118) et du deuxième transistor (94) de la première branche (88) étant reliés ensemble à un noeud d'application d'une tension de consigne (Vref), les noeuds de commande du cinquième transistor (120) et du deuxième transistor (108) de la deuxième branche (90) étant reliés ensemble à un noeud de sortie (22) du régulateur.

2. Dispositif selon la revendication 1, dans lequel les premiers transistors (92, 106) des première (88) et deuxième (90) branches sont des transistors MOSFET à canal P, les deuxièmes (94, 108) et troisièmes (96, 110) transistors des première (88) et deuxième (90) branches sont des transistors MOSFET à canal N.

3. Dispositif selon la revendication 1 ou 2, dans lequel le régulateur comprend, reliés dans cet ordre en série entre les premier (24) et deuxième (46) noeuds, des sixième (82) et septième (80) transistors, une première résistance (78), et des huitième (60) et neuvième (62) transistors, le noeud de commande du sixième transistor (82) étant relié au point milieu du septième transistor (80) et de la résistance (78), le noeud de commande du sixième transistor (82) étant en outre relié aux noeuds de commande des premiers transistors (92, 106) des première (88) et deuxième (90) branches, le noeud de commande du septième transistor (80) étant relié au point milieu du huitième transistor (60) et de la résistance (78).

4. Dispositif selon la revendication 3, dans lequel le régulateur comprend, reliés dans cet ordre en série entre les premier (24) et deuxième (46) noeuds, une source de courant (74), une deuxième résistance (72), et des dixième (56) et onzième (58) transistors, le noeud de commande du dixième transistor (56) étant relié au point milieu de la deuxième résistance (72) et de la source de courant (74) et au noeud de commande du huitième transistor (62), le noeud de commande du onzième transistor (58) étant relié au noeud de commande du neuvième transistor (62).

5. Dispositif selon la revendication 3 ou 4, dans lequel le régulateur comprend des douzième (28), treizième (50) et quatorzième (52) transistors reliés, dans cet ordre, en série entre les premier (24) et deuxième (46) noeuds, un noeud de commande du quatorzième transistor (52) étant relié au noeud de commande du troisième transistor (96) de la première branche (88).

6. Dispositif selon la revendication 5, dans lequel le régulateur comprend des quinzième (32), seizième (42) et dix-septième (44) transistors reliés, dans cet ordre, en série entre les premier (24) et deuxième (46) noeuds, un noeud de commande du dix-septième transistor (44) étant relié au noeud de commande du troisième transistor (110) de la deuxième branche (90), un noeud de commande du quinzième transistor (32) étant relié au noeud de commande du douzième transistor (28).

7. Dispositif selon la revendication 6, dans lequel un noeud de commande du seizième transistor (42) est relié au noeud de commande du huitième transistor (60), un noeud de commande du treizième transistor (50) étant relié au noeud de commande du huitième transistor (60)

8. Dispositif selon la revendication 3 et la revendication 5 ou 6, dans lequel le régulateur comprend un dix-neuvième transistor (30), le dix-neuvième transistor (30) étant relié en série entre les douzième (28) et treizième (50) transistors, un noeud de commande du dix-neuvième transistor (30) étant relié au noeud de commande du septième transistor (80), un noeud de commande du douzième transistor (28) étant relié au point milieu des dix-neuvième (30) et treizième (50) transistors.

9. Dispositif selon la revendication 8, dans lequel le régulateur comprend un vingtième transistor (34), le vingtième transistor (34) étant relié en série entre les quinzième (32) et seizième (42) transistors, un noeud de commande du vingtième transistor (34) étant relié au noeud de commande du dix-neuvième transistor (36).

10. Dispositif selon la revendication 9, dans lequel le dispositif comprend des vingt-et-unième (146), vingt-deuxième (148) et vingt-troisième (150) transistors reliés, dans cet ordre, en série entre les premier (24) et deuxième (46) noeuds, un noeud de commande du vingt-et-unième transistor (146) est relié au noeud de commande du sixième transistor (82), un noeud de commande du vingt-deuxième transistor (148) est relié au noeud de commande du septième transistor (80), un noeud de commande du vingt-troisième transistor (150) est relié au noeud de commande du treizième transistor (50), le noeud de commande du vingt-troisième transistor (150) étant en outre relié au point milieu entre le vingt-deuxième transistor (148) et le vingt-troisième transistor (150), le dispositif comprenant des vingt-quatrième (158), vingt-cinquième (160) et vingt-sixième (162) transistors reliés, dans cet ordre, en série entre les premier (24) et deuxième (46) noeuds, un noeud de commande du vingt-quatrième transistor (158) est relié au noeud de commande du sixième transistor (82), un noeud de commande du vingt-cinquième transistor (160) est relié au noeud de commande du septième transistor (80), un noeud de commande du vingt-sixième transistor (162) est relié au noeud de commande du neuvième transistor (62), le dispositif comprenant en outre un troisième condensateur (170) relié entre le point milieu des vingt-quatrième (158) et vingt-cinquième (160) transistors et le point milieu des vingtième(34) et seizième (42) transistors.

11. Dispositif selon la revendication 9, dans lequel le dispositif comprend des vingt-et-unième (146), vingt-deuxième (148) et vingt-troisième (150) transistors reliés, dans cet ordre, en série entre les premier (24) et deuxième (46) noeuds, un noeud de commande du vingt-et-unième transistor (146) est relié au noeud de commande du sixième transistor (82), un noeud de commande du vingt-deuxième transistor (148) est relié au noeud de commande du septième transistor (80), un noeud de commande du vingt-troisième transistor (150) est relié au noeud de commande du treizième transistor (50), le noeud de commande du vingt-troisième transistor (150) étant en outre relié au point milieu entre le vingt-deuxième transistor (148) et le vingt-troisième transistor (150), le dispositif comprenant des vingt-cinquième (160) et vingt-sixième (162) transistors reliés, dans cet ordre, en série entre le point milieu des premier (106) et deuxième (108) transistors de la deuxième branche (90) et le deuxième (46) noeud, un noeud de commande du vingt-cinquième transistor (160) est relié au noeud de commande du septième transistor (80), un noeud de commande du vingt-sixième transistor (162) est relié au noeud de commande du neuvième transistor (62), le point milieu des vingt-cinquième (160) et vingt-sixième (162) transistors étant relié au point milieu des premier (106) et deuxième (108) transistors de la deuxième branche (90), le dispositif comprenant des vingt-septième (202) et vingt-huitième (204) transistors reliés, dans cet ordre, en série entre le point milieu des premier (92) et deuxième (94) transistors de la première branche (88) et le deuxième (46) noeud, un noeud de commande du vingt-septième transistor (202) est relié au noeud de commande du septième transistor (80), un noeud de commande du vingt-huitième transistor (204) est relié au noeud de commande du neuvième transistor (62), le point milieu des vingt-septième (202) et vingt-huitième (204) transistors étant relié au noeud de commande du troisième transistor (96) de la première branche (88), le dispositif comprenant en outre un troisième condensateur (170) relié entre le point milieu des premier (106) et deuxième (108) transistors et le point milieu des vingtième(34) et seizième (42) transistors.

12. Dispositif selon l'une quelconque des revendications 1 à 11, dans lequel le régulateur comprend un dix-huitième transistor (26) relié entre le premier noeud (24) et le noeud de sortie (22) du régulateur.

13. Dispositif selon les revendications 9 et 12 dans son rattachement à la revendication 6, dans lequel un noeud de commande du dix-huitième transistor (26) est relié au point milieu des vingtième (34) et seizième (42) transistors.

14. Dispositif selon la revendication 13, dans lequel un noeud de commande du dix-huitième transistor (26) est relié au point milieu des vingtième (34) et seizième (42) transistors par un amplificateur opérationnel (172), une entrée non inverseuse de l'amplificateur opérationnel étant reliée au point milieu des vingtième(34) et seizième (42) transistors, une entrée inverseuse de l'amplificateur opérationnel (172) est reliée à une sortie de l'amplificateur opérationnel (172), la sortie de l'amplificateur opérationnel (172) étant en outre reliée au noeud de commande du dix-huitième transistor (26).

15. Dispositif selon les revendications 6 et 7, dans lequel un noeud de commande du treizième transistor (28) est relié au point milieu des treizième (28) et quatorzième (50) transistors, un noeud de commande du dix-huitième transistor (26) étant relié au point milieu des quinzième (32) et seizième (42) transistors.

16. Dispositif selon l'une quelconque des revendications 7 à 15 dans son rattachement à la revendication 6, dans lequel le régulateur comprend un premier (124) condensateur de Miller, le premier condensateur étant relié entre le noeud de sortie du régulateur et le point milieu des seizième (42) et dix-septième (44) transistors.

17. Dispositif selon l'une quelconque des revendications 1 à 16, dans lequel le régulateur comprend un deuxième (126) condensateur de Miller, le deuxième condensateur étant relié entre le noeud de sortie du régulateur et le noeud de commande du troisième transistor de la première branche.
